# EUROPEAN PATENT APPLICATION

(11) **EP 4 770 413 A2**
(43) Date of publication of application: **01.07.2026**
(21) Application number: 25216596.4
(22) Date of filing: 18.11.2025
(51) Int. Cl.: H10W 72/00

(54) **HEAT TRANSFER COUPLER THAT INCLUDES A CAVITY**

(30) Priority: 27.12.2024 US 202419003654
(71) Applicant: Intel Corporation, Santa Clara, CA 95054 (US)
(72) Inventor: SRINIVASAN, Kartik, Gilbert, AZ 85298 (US); CETEGEN, Edvin, Chandler, AZ 85226 (US); KAYA, Mine, Chandler, AZ 85226 (US); OKA, Mihir, Gilbert, AZ 85296 (US); MELLODY, James P., Phoenix, AZ 85021 (US); TAN, Wei, Chandler, AZ 85248 (US); GOKHALE, Shripad, Gilbert, AZ 85298 (US); ZHONG, Shan, Chandler, AZ 85286 (US); GOSSELIN, Timothy, Phoenix, AZ 85012 (US); RUMER, Christopher, Chandler, AZ 85248 (US)
(74) Representative: HGF

(57) **Abstract**

Heat transfer couplers, which can also be referred to as nozzles, for semiconductor manufacturing are provided. The heat transfer couplers can include a cavity on a side that is opposite the side a semiconductor chip is attached to during an assembly process. In the assembly process, the semiconductor chip can be electrically coupled to a package substrate forming electrical interconnects. The assembly process can be a thermocompression bonding process in which first level interconnects are formed.

## Description

### FIELD

Descriptions are generally related to semiconductor manufacturing, and more particular descriptions are related to a coupler for heat transfer that includes a cavity wherein the coupler can be used to, for example, transfer heat to create first level interconnects between a semiconductor chip and a package substrate.

### BACKGROUND

Semiconductor chips are central to intelligent devices and systems, such as personal computers, laptops, tablets, phones, servers, and other consumer and industrial products and systems. Manufacturing semiconductor chips presents a number of challenges and these challenges are amplified as devices become smaller and performance demands increase. Challenges include, for example, unwanted material interactions, precision and scaling requirements, power delivery requirements, limited failure tolerance, and material and manufacturing costs.

Semiconductor chips are typically "packaged" by attaching them to a package substrate that provides interconnections for power and signal input/output (I/O). The package substrate can act as an interface between the semiconductor chip and other levels of interconnections, such as those for a socket interconnection or other types of interfaces or circuit board interconnections. The interconnections between a semiconductor chip and a package substrate can be considered first level interconnects (FLIs). Conducting interconnects, such as FLIs, can be created, for example, through thermal compression bonding (TCB) processes. A TCB process can use heat and mechanical pressure to create a metallurgical bond that forms the interconnections. A TCB process can create, for example, a copper to copper bond between bumps (or regions having other shapes) on the semiconductor chip and corresponding pads (or regions having other shapes) on the package substrate.

### BRIEF DESCRIPTION OF THE DRAWINGS

The figures are provided to aid in understanding the disclosure. The figures can include diagrams and illustrations of examples of structures, assemblies, data, methods, and systems. For ease of explanation and understanding, these structures, assemblies, data, methods, and systems, the figures are not an exhaustively detailed description. The figures therefore should not be understood to depict the entire metes and bounds of structures, assemblies, data, methods, and systems possible without departing from the scope of the disclosure. Additionally, features are not necessarily illustrated relatively to scale due in part to the small sizes of some features and the desire for clarity of explanation in the figures.
**Figure 1** illustrates an assembly that is useful for coupling a semiconductor die to a substrate using, for example, a thermocompression bonding (TCB) process.
**Figures 2A** - **2B** show opposite sides of a heat transfer coupler that can be used to manufacture semiconductor device assemblies.
**Figures 3A - 3B** illustrate opposite sides of a second example of a heat transfer coupler that can be used to manufacture semiconductor device assemblies.
**Figure 4** provides a method for manufacturing a semiconductor device assembly comprising a semiconductor chip and a substrate.
**Figure 5** provides an example of a computing system.

Descriptions of certain details and implementations follow, including non-limiting descriptions of the figures, which depict some examples and implementations.

### DETAILED DESCRIPTION

References to one or more examples are to be understood as describing a particular feature, structure, or characteristic included in at least one implementation. The phrases "one example" or "an example" are not necessarily all referring to the same example or implementation. Any aspect described herein can potentially be combined with any other aspect or similar aspect described herein, regardless of whether the aspects are described with respect to the same figure or element.

The words "connected" and/or "coupled" can indicate that two or more elements are in direct physical or electrical contact with each other. The term "coupled," however, can also mean that two or more elements are not in direct contact with each other and are instead separated by one or more elements but they may still co-operate or interact with each other, for example, physically, magnetically, optically, or electrically.

The words "first," "second," and the like, do not indicate order, quantity, or importance, but rather are used to distinguish one element from another. The words "a" and "an" herein do not indicate a limitation of quantity, but rather denote the presence of at least one of the referenced items. The terms "follow" or "after" can indicate immediately following or following some other event or events. Other sequences of operations can also be performed according to alternative implementations. Furthermore, additional operations may be added or removed depending on the application.

Disjunctive language such as the phrase "at least one of X, Y, or Z," is used in general to indicate that an element or feature, may be either X, Y, or Z, or any combination thereof (e.g., X, Y, and/or Z). Thus, this disjunctive language should be understood not to imply that certain implementations require at least one of X, at least one of Y, or at least one of Z to each be present.

Flow diagrams as illustrated herein provide examples of sequences of various process actions. The flow diagrams can indicate operations to be executed by a software or firmware routine, as well as by physical operations. Physical operations can be performed by semiconductor processing and/or testing equipment, including computer systems that run testing protocols and operate aspects of testing equipment and systems. Although shown in a particular sequence or order, unless otherwise specified, the order of the actions can be modified. Thus, the illustrated diagrams should be understood as examples. The processes can be performed in a different order, and some actions can be performed in parallel. Additionally, one or more actions can be omitted and not all implementations may necessarily perform all actions.

Various components described can be a means for performing the operations or functions described. Components described can include software, hardware, or a combination of these. Some components can be implemented as software modules, hardware modules, special-purpose hardware (for example, application specific hardware, application specific integrated circuits (ASICs), and digital signal processors (DSPs)), embedded controllers, and/or hardwired circuitry. Other components can be semiconductor processing and/or testing equipment that is able to perform physical operations such as, for example, lithography, material deposition (for example, chemical vapor deposition (CVD), atomic layer deposition (ALD), physical vapor deposition (PVD), electrodeposition, electroplating, and/or sputtering), chemical mechanical polishing, etching, pick and place operations, and thermal compression bonding.

To the extent various computer operations or functions are described herein, they can be described or defined as software code, instructions, configuration, and/or data. The software content can be provided via an article of manufacture with the content stored thereon, or via a method of operating a communication interface to send data via the communication interface. A machine-readable storage medium can cause a machine to perform the functions or operations described. A machine-readable storage medium includes any mechanism that stores information in a tangible form accessible by a machine (e.g., computing device), such as recordable/non-recordable media (e.g., read only memory (ROM), random access memory (RAM), magnetic disk storage media, optical storage media, flash memory devices). Instructions can be stored on the machine-readable storage medium in a non-transitory form. A communication interface includes any mechanism that interfaces to, for example, a hardwired, wireless, or optical medium to communicate to another device, such as, for example, a memory bus interface, a processor bus interface, an Internet connection, a disk controller.

Terms such as chip, die, IC (integrated circuit) chip, IC die, microelectronic chip, microelectronic die, semiconductor die, semiconductor device, and/or semiconductor chip are interchangeable and refer to a device comprising integrated circuits that can be formed in part from semiconductor materials.

The terms "package," "packaging," "IC package," or "chip package," "microelectronics package," or "semiconductor chip package" are interchangeable and generally refer to an enclosed carrier of one or more chips, in which the chips are coupled to a package substrate and encapsulated. The package substrate provides electrical interconnections between the chip(s) and other chips and/or a motherboard or other circuit board for I/O (input/output) communication and power delivery. A package with multiple chips can, for example, be a system in a package.

A package substrate generally includes dielectric layers or structures having conductive structures on, through, and/or embedded in the dielectric layers. The dielectric layers can be, for example, build-up layers. Dielectric materials include Ajinomoto build-up film (ABF), although other dielectric materials are possible. Semiconductor package substrates can have cores or be coreless. Semiconductor packages having cores can have dielectric layers such as buildup layers on more than one side of a core, such as on two opposite sides of a core. Cores can include through-core vias that contain a conductive material. Other structures or devices are also possible within a package substrate.

A "core" or "package core" generally refers to a layer usually embedded within a package substrate. The core can provide structure or stiffness to a package substrate. A core is an optional feature of a package substrate. The core can be a dielectric organic or inorganic material and may have conductive vias extending through the layer. The conductive vias can include a metal, for example, copper. A package core can, for example, be comprised of a glass material (such as, for example, aluminosilicate, borosilicate, alumino-borosilicate, silica, and fused silica), silicon, silicon nitride, silicon carbide, gallium nitride, or aluminum oxide. In some examples, core materials are glass-fiber reinforced organic resins such as epoxy-based resins. A further example package substrate core is FR4 (woven glass fiber reinforces epoxy). In other examples, package substrate cores are solid amorphous glass layers.

In further examples of a package substrate core, the substrate core is a glass core comprising one or more solid amorphous glass layers. The glass substrate core can comprise a glass such as, for example, aluminosilicate, borosilicate, alumino-borosilicate, silica, and fused silica, that additionally optionally comprises one or more of the following: Al₂O₃, B₂O₃, MgO, CaO, SrO, BaO, SnO₂, Na₂O, K₂O, SrO, P₂O₃, ZrO₂, Li₂O, Ti, and/or Zn. In further examples of glass cores, the glass can comprise silicon and oxygen, as well as optionally any one or more of: aluminum, boron, magnesium, calcium, barium, tin, sodium, potassium, strontium, phosphorus, zirconium, lithium, titanium, and/or zinc. In some examples, a glass package substrate core comprises at least 23 % silicon, at least 26 % oxygen by weight. In further examples, the glass package substrate core comprises at least 23 % silicon, at least 26 % oxygen, and at least 5 % aluminum by weight.

Additionally, examples of solid amorphous glass substrate cores can be considered to have a rectangular prism volume. The rectangular prism volume can contain vias that have been filled with one or more different materials. A rectangular prism volume can be an approximate description of the shape in that corners can be rounded or chamfered and/or the thickness of the glass layer can be inconsistent. A material in a via can be a conductive metal such as copper. Examples of solid amorphous glass substrate cores can have a thickness in the range of 50 µm to 1.4 mm. Additionally, the package substrate can include a multi-layer glass substrate. The package substrate in this example may be a coreless substrate. The multi-layer glass substrate can have a thickness, for example, in the range of 25 µm to 50 µm. Further, glass substrate cores can have dimensions on a side of 10 mm to 250 mm. For example, the substrate core can be 10 mm by 10 mm up to 250 mm by 250 mm in two dimensions, but substrate cores do not necessarily have to have the same value in both dimensions.

A package substrate can include one or more interconnect bridges. The interconnect bridge can be partially, fully, or not embedded into the package substrate. An interconnect bridge provides interconnects between chips that are housed on the package substrate. The interconnects can provide signal I/O between the chips. Some interconnect bridges, such as ones that have conductive through-bridge vias, can also provide power to an operably connected chip. The interconnect bridge can include regions having traces that have a smaller width dimension (the smallest dimension of the trace), a smaller height dimension, and/or a length dimension than the vias and traces of the surrounding package substrate. For example, width dimensions (or smallest dimension) can be 3 µm or less and/or 10 µm or less in some regions. The interconnect bridges can also have smaller trace spacings than the surrounding package substrate. For example, trace center-to-center spacings can be 3 µm and/or less or 10 µm or less in some regions. The interconnect bridge substrate can comprise, for example, silicon, silicon-on-insulator, float glass, borosilicate glass, silicon dioxide, polymeric, one or more organic polymeric materials, ceramic, and/or a silicon nitride material. The interconnect bridge substrate can comprise, for example, one or more dielectric layers that are comprise of, silicon oxides, silicon nitride, silicon oxynitride, carbon-doped oxide, methyl silsesquioxane, hydrogen silsesquioxane, die backside film (DBF), an epoxy film, a B-stage epoxy film, other dielectric material. The interconnect bridge can also include a coreless substrate comprised of a plurality of dielectric layers. The dielectric layers can be, for example, die backside film (DBF), an epoxy film, a B-stage epoxy film, or other dielectric material. Other materials are also possible for interconnect bridge substrates. Other materials are possible.

For packages that include interconnect bridges, the pitch in the interconnect bridge region for first level interconnects (FLIs) assemblies can be less than the pitch for other regions of the FLI assembly. The pitch in the interconnect bridge region for FLIs can be, for example, less than or equal to 25 µm.

Incorporating through-bridge vias (TBVs) into interconnect bridges can enable power to be routed from a substrate package cavity to a semiconductor device attached to a package substrate. Through-bridge-vias can reduce the number of substrate routing layers required in a package substrate and can result in improved packaging yields. An interconnect bridge having TBVs can be for example, EMIB with TBVs, or EMIB-T. Depending on the bridge substrate material, a TBV may also be described as a through-silicon via (TSV) if the via traverses a region comprised of silicon, for example.

Thermal compression bonding (TCB) processes can employ heat and mechanical pressure to form conducting interconnects between a semiconductor chip (die) and a substrate (e.g., a package substrate, a semiconductor chip, an active interposer, or an interposer). The application of heat to a semiconductor chip and/or substrate can cause in-plane (x,y plane) and/or z-direction expansions in these devices during TCB processes. Unwanted in-plane and/or z-direction expansions can lead to opens and yield losses in resulting assemblies. Additionally, failure modes can include die blistering and delamination in which layers of materials that make up a die become separated. Failure modes during manufacturing (for example, opens, die blistering, and/or die delamination) can be exacerbated by temperature gradients across the semiconductor die and/or the substrate during TCB processes.

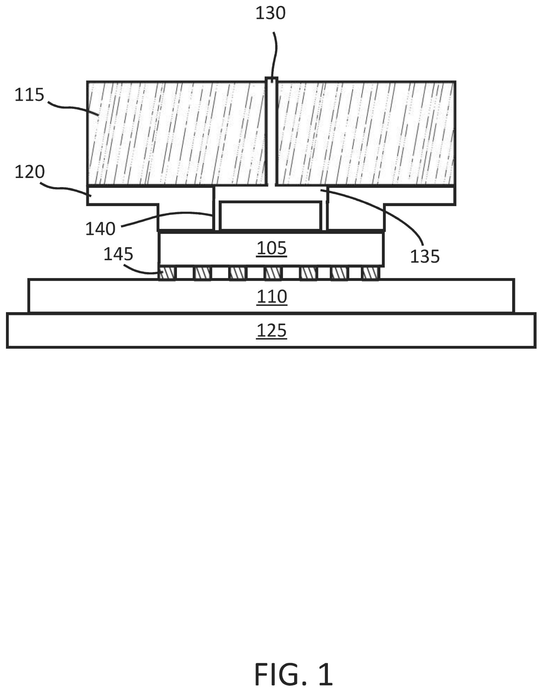

Figure 1 provides a manufacturing assembly that is useful for a TCB process and a semiconductor die 105 and a substrate 110 that are to be bonded together using the manufacturing assembly. The manufacturing assembly includes a heater 115 and a heat transfer coupler 120. Additional parts of the assembly that are not shown can include, for example, mechanical systems for applying pressure so that the semiconductor die 105 is pressed toward the substrate 110 and vacuum systems that allow a vacuum to be applied through channels (e.g., heater channels 130 and coupler channels 140). Other locations, sizes, and/or shapes are possible for heater channels 130 and coupler channels 140. The manufacturing assembly can also include a pedestal 125 that can be, for example, a vacuum pedestal that is adapted to holding a packaging substrate 110 during manufacturing processes. The heater 115 can include one or more heater channels 130 through which a vacuum can be applied. Heaters 115 that are useful in TCB process systems can be, for example, multilayer composite stacks comprising a high conductivity ceramic material with heating traces. A high conductivity ceramic material can be aluminum nitride and the heating traces can be comprised of tungsten. A heat transfer coupler 120 can also be referred to as a nozzle or a thermal compression bonding nozzle. The heat transfer coupler 120 includes a cavity 135 and coupler channels 140. A vacuum can be applied through coupler channels 140. A vacuum applied through coupler channels 140 can secure the semiconductor die 105 to the heat transfer coupler 120.

A TCB process can form conductive interconnects 145 between a substrate 110 and a semiconductor die 105. Conductive interconnects 145 can be ones that are formed through the application of heat or the application of heat and mechanical pressure. For example, the conductive interconnect 145 can comprise gold, copper, silver, bismuth, lead nickel, aluminum, solder, and/or conducting adhesives. The conductive interconnects 145 can be a physical join between a bump, a pin, a rod, a solder region, a conducting adhesive region, or other shaped region, and a rod, a pad, or other shaped region. The conductive interconnects 145 can be formed, for example, using a bonding process that is controlled collapse chip connection (C4) or flip chip process. Additionally, the conductive interconnects 145 can be formed using a hybrid bonding process. A connection process can alternatively employ a bump shaped conducting region and a conductive adhesive to form the conductive interconnects 145.

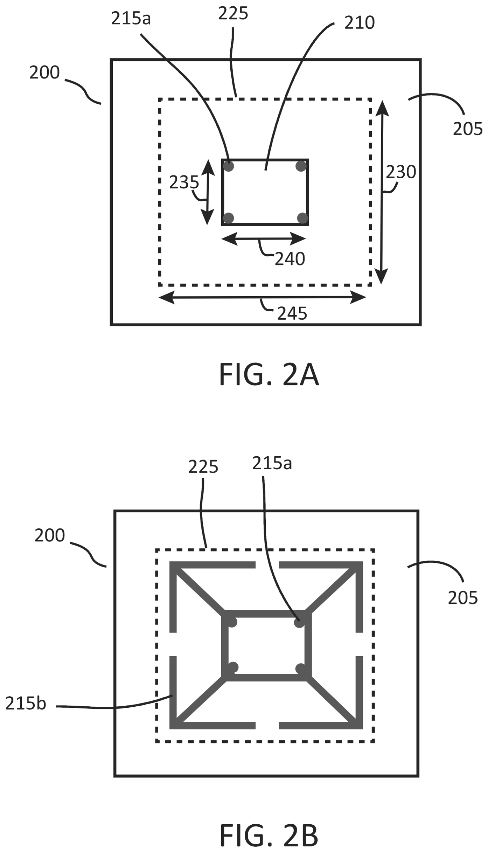

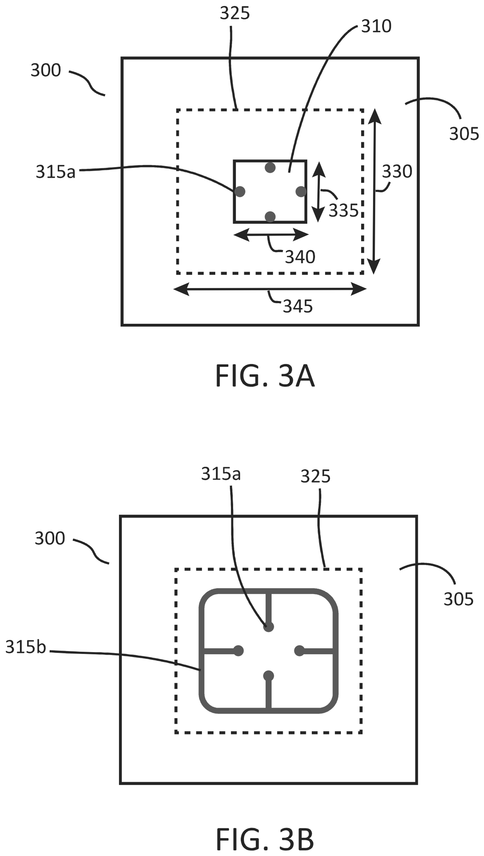

Figures 2A - 2B and Figures 3A - 3B provide examples of heat transfer couplers that can be used in manufacturing processes in which interconnects are formed in which the interconnects electrically couple a semiconductor die to a substrate. The heat transfer couplers 200 and 300 of Figures 2A - 2B and Figures 3A - 3B can be, for example the heat transfer coupler 120 of Figure 1. A first side of the heat transfer coupler 200 (depicted in Figure 2A) includes a solid body 205 and a cavity 210 in the solid body 205. Cavity 210, can be for example, the cavity 135 of Figure 1. The cavity 210 can be centered in a face of the solid body 205 and/or centered on the face of a semiconductor chip during an assembly manufacturing process. The first side of the heat transfer coupler 200 can contact a face of a heater (not shown), such as heater 115 and as shown in Figure 1. The solid body 205 of the heat transfer coupler can be comprised of a thermally conductive material, such as, for example, a metallic material, such as, copper, aluminum, or alloys thereof, and/or one or more layers or coatings of the foregoing materials. Alternatively, the solid body 205 of the heat transfer coupler can be comprised of a ceramic material, such as silicon carbide (SiC), aluminum nitride (AlN), titanium nitride, or diamond. The diamond can be comprise of diamond material that was deposited by a chemical vapor deposition (CVD) process. Other materials are possible

The heat transfer coupler 200 can also include channels 215a and 215b through which a vacuum can be applied. The second side of heat transfer coupler 200 (depicted in Figure 2B) can contact a face of a semiconductor chip, such as the semiconductor chip 105 of Figure 1.

A dashed line illustrates a semiconductor chip outline 225 for a side (or face) of a semiconductor chip that can be positioned against the second side of heat transfer coupler 200 (Figure 2B). The length of a side of a semiconductor chip (outline 225) is represented by double-sided arrows 230 and 245, such that the length of double-sided arrow 230 multiplied by the length of double-sided arrow 245 is the area of a side of a semiconductor chip that is positioned against second side of heat transfer coupler 200. The length of a side of cavity 210 is represented by double-sided arrows 235 and 240. The area of a face of the cavity 210 can be calculated by multiplying the length of double-sided arrow 235 by the length of double-sided arrow 245. The area of a face of the cavity 210 can be between 5 % and 50 %, between 10 % and 45 %, or between 20 % and 40 % of the area of a side of a semiconductor chip that is to be positioned against second side of heat transfer coupler 200. Although the area of the face of the cavity 210 can depend on the size of the die being bonded, an example area of a face of the cavity 210 can be between 2 mm² and 12 mm². Other values are also possible.

A first side of the heat transfer coupler 300 (depicted in Figure 3A) includes a solid body 305 and a cavity 310 in the solid body 305. Cavity 310, can be for example, the cavity 135 of Figure 1. The cavity 310 can be centered in a face of the solid body 305 and/or centered on the face of a semiconductor chip during an assembly manufacturing process. The first side of the heat transfer coupler 300 can contact a face of a heater (not shown), such as heater 115 and as shown in Figure 1. The solid body 305 of the heat transfer coupler can be comprised of a thermally conductive material, such as, for example, a metallic material, such as, copper, aluminum, or alloys thereof, and/or one or more layers or coatings of the foregoing materials. Alternatively, the solid body 305 of the heat transfer coupler can be comprised of a ceramic material, such as silicon carbide (SiC), aluminum nitride (AlN), titanium nitride, or diamond. The diamond can be comprise of diamond material that was deposited by a chemical vapor deposition (CVD) process. Other materials are possible. The heat transfer coupler 300 can also include channels 315a and 315b through which a vacuum can be applied. The second side of heat transfer coupler 300 (depicted in Figure 3B) can contact a face of a semiconductor chip, such as the semiconductor chip 105 of Figure 1.

A dashed line illustrates a semiconductor chip outline 325 for a side (or face) of a semiconductor chip that can be positioned against the second side of heat transfer coupler 300 (Figure 3B). The length of a side of a semiconductor chip (outline 325) is represented by double-sided arrows 330 and 345, such that the length of double-sided arrow 330 multiplied by the length of double-sided arrow 345 is the area of a side of a semiconductor chip that is positioned against second side of heat transfer coupler 300. The length of a side of cavity 310 is represented by double-sided arrows 335 and 340. The area of a face of the cavity 310 can be calculated by multiplying the length of double-sided arrow 335 by the length of double-sided arrow 345. The area of a face of the cavity 310 can be between 5 % and 50 %, between 10 % and 40 %, or between 20 % and 40 % of the area of a side of a semiconductor chip that is to be positioned against second side of heat transfer coupler 200. Although the area of the face of the cavity 310 can depend on the size of the die being bonded, an example area of a face of the cavity 310 can be between 2 mm² and 12 mm². Other values are also possible.

Other shapes, sizes, and relative lengths are possible for a useful heat transfer coupler and heat transfer coupler cavity, other than the ones illustrated as examples in Figures 2A - 2B and Figures 3A - 3B. For example, a useful heat transfer coupler can be designed for a specific semiconductor chip and package assembly for which it is being employed during a manufacturing process. Additionally, although, for simplicity of illustration, one semiconductor chip is shown, however it can be the case that a plurality of chips are coupled to a package substrate, a semiconductor chip, an active interposer, or interposer (a substrate) in a manufacturing process. One heat transfer coupler can be used for multiple chips in which the heat transfer coupler comprises multiple cavities, or multiple heat transfer couplers can be used where each heat transfer coupler serves an individual chip, or a combination of heat transfer couplers can be used, some serving one chip and some serving multiple chips. Further, other arrangements for channels 215a, 215b, 315a, and 315b are also possible. Additionally, although a vacuum is shown as being supplied through the heater, other arrangements for vacuum supply are possible, such as through a different face of the heat transfer coupler. A heat transfer coupler can also comprise multiple cavities for one semiconductor chip so that a single cavity area is broken up into multiple smaller cavities.

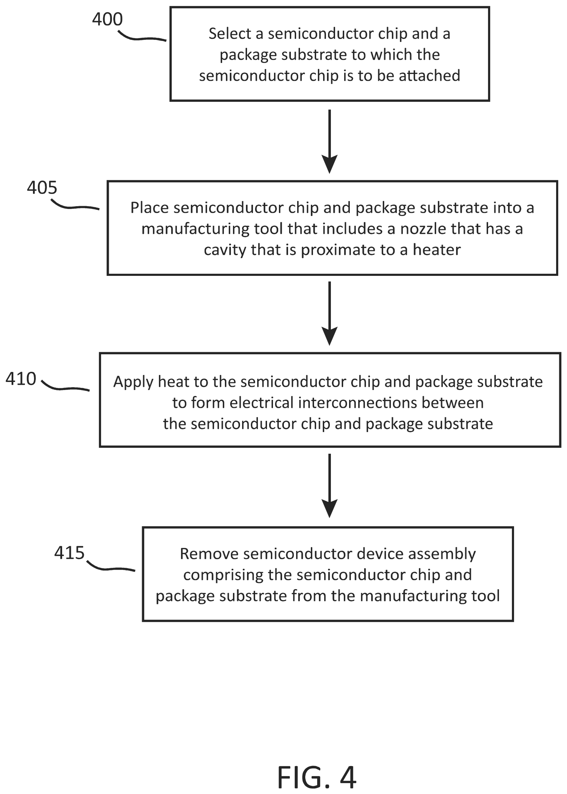

Figure 4 diagrams a method for manufacturing an assembly comprising a semiconductor chip and a substrate. In Figure 4, one or more semiconductor chips that are to be functionally electrically coupled to a substrate are selected 400. The substrate and one or more semiconductor chips are placed in a manufacturing tool 405. The manufacturing tool can comprise one or more heat transfer couplers as shown and described herein with respect to Figures 1, 2A - 2B, and/or 3A - 3B. Heat can be applied through the heat transfer coupler to form electrical connections between the semiconductor chip and the substrate 410. The semiconductor chip can comprise bumps, pads, pins, or solder regions that are joined to a corresponding region on the substrate (such as a bump, pad, pin, or solder region) through the manufacturing process. The manufacturing process can be a TCB process in which a metallurgical bond is formed between metal regions on the semiconductor chip and metal regions on the substrate. The metal regions can be comprised of, for example, copper, tin, bismuth, lead, nickel, or an alloy of one or more of the foregoing. The manufacturing process can additionally comprise the application of pressure the semiconductor chip and substrate to cause the formation of electrical connections. A TCB compression process typically employs a linear motor that operates with precision and accuracy and that can move in a compression direction with precision. An assembly comprising at least one semiconductor chip and substrate, where the semiconductor chip is operably coupled to the substrate can be removed from the manufacturing tool 415. The substrate can be, for example, a package substrate, an active interposer, a semiconductor chip, or an interposer.

A manufacturing tool can additionally comprise a vacuum supply system, in which vacuum can be applied to the heat transfer coupler and/or to a vacuum pedestal. The heat transfer coupler can hold a semiconductor chip in place during the manufacturing process through the application of a vacuum. The pedestal can hold a substrate in place through the application of a vacuum.

It can be possible to supply heat evenly to the surface of the semiconductor chip using a heat transfer coupler as shown and described herein with respect to Figures 1, 2A - 2B, and/or 3A - 3B, so that a change in temperature across a semiconductor device (i.e., the in-plane thermal non-uniformity) is less than 10°C. The in-plane thermal uniformity can be a function of chip size, so that a larger chip is expected to have poorer uniformity. As compared to a system employing a heat transfer coupler without a cavity, it can be the case that a reduction of as much as 15 °C in peak FLI temperature can be achieved.

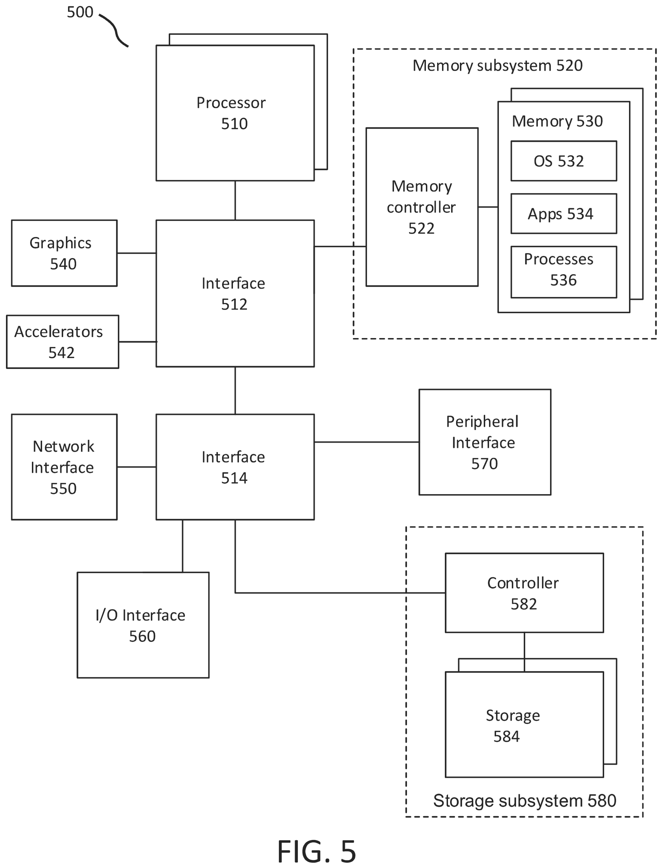

Semiconductor devices (or chips) can be any combination of microprocessors, CPUs (central processing units), GPUs (graphics processing units), processing cores, system on a chips, other processing hardware, a combination of processors or processing cores, programmable general-purpose or special-purpose microprocessors, accelerators, DSPs, I/O management, programmable controllers, ASICs, programmable logic devices (PLDs), HBM, and/or other memory devices. Semiconductor chip package assemblies can be heterogeneous packages that incorporate different types of chips into one package. The semiconductor chips can be any of the chips, for example, described herein with respect to Figure 5.

Figure 5 depicts an example computing system which can be used in conjunction with manufacturing tools. The computing system can be a system used for running equipment in a semiconductor fabrication plant. For example, instructions for performing one or more aspects of the process described in Figure 4 can be stored and/or run on the computing system. A computing system 500 can include more, different, or fewer features than the ones described with respect to Figure 5.

Computing system 500 includes processor 510, which provides processing, operation management, and execution of instructions for system 500. Processor 510 can include any type of microprocessor, CPU (central processing unit), GPU (graphics processing unit), processing core, or other processing hardware to provide processing for system 500, or a combination of processors or processing cores. Processor 510 controls the overall operation of system 500, and can be or include, one or more programmable general-purpose or special-purpose microprocessors, DSPs, programmable controllers, ASICs, programmable logic devices (PLDs), or the like, or a combination of such devices.

In one example, system 500 includes interface 512 coupled to processor 510, which can represent a higher speed interface or a high throughput interface for system components needing higher bandwidth connections, such as memory subsystem 520 or graphics interface components 540, and/or accelerators 542. Interface 512 represents an interface circuit, which can be a standalone component or integrated onto a processor die. Where present, graphics interface 540 interfaces to graphics components for providing a visual display to a user of system 500. In one example, the display can include a touchscreen display.

Accelerators 542 can be a fixed function or programmable offload engine that can be accessed or used by a processor 510. For example, an accelerator among accelerators 542 can provide data compression (DC) capability, cryptography services such as public key encryption (PKE), cipher, hash/authentication capabilities, decryption, or other capabilities or services. In some cases, accelerators 542 can be integrated into a CPU socket (e.g., a connector to a motherboard (or circuit board, printed circuit board, mainboard, system board, or logic board) that includes a CPU and provides an electrical interface with the CPU). For example, accelerators 542 can include a single or multi-core processor, graphics processing unit, logical execution unit single or multi-level cache, functional units usable to independently execute programs or threads, application specific integrated circuits (ASICs), neural network processors (NNPs), programmable control logic, and programmable processing elements such as field programmable gate arrays (FPGAs) or programmable logic devices (PLDs). Accelerators 542 can provide multiple neural networks, CPUs, processor cores, general purpose graphics processing units, or graphics processing units can be made available for use by artificial intelligence (AI) or machine learning (ML) models.

Memory subsystem 520 represents the main memory of system 500 and provides storage for code to be executed by processor 510, or data values to be used in executing a routine. Memory subsystem 520 can include one or more memory devices 530 such as read-only memory (ROM), flash memory, one or more varieties of random access memory (RAM) such as static RAM (SRAM), dynamic RAM (DRAM), synchronous DRAM (SDRAM) and/or or other memory devices, or a combination of such devices. Memory 530 stores and hosts, among other things, operating system (OS) 532 that provides a software platform for execution of instructions in system 500, and stores and hosts applications 534 and processes 536. In one example, memory subsystem 520 includes memory controller 522, which is a memory controller to generate and issue commands to memory 530. The memory controller 522 can be a physical part of processor 510 or a physical part of interface 512. For example, memory controller 522 can be an integrated memory controller, integrated onto a circuit within processor 510.

System 500 can also optionally include one or more buses or bus systems between devices, such memory buses, graphics buses, and/or interface buses. Buses or other signal lines can communicatively or electrically couple components together, or both communicatively and electrically couple the components. Buses can include physical communication lines, point-to-point connections, bridges, adapters, controllers, or other circuitry or a combination. Buses can include, for example, one or more of a system bus, a peripheral component interface (PCI) or PCI express (PCIe) bus, a Hyper Transport or industry standard architecture (ISA) bus, a small computer system interface (SCSI) bus, a universal serial bus (USB), or a Firewire bus.

In one example, system 500 includes interface 514, which can be coupled to interface 512. In one example, interface 514 represents an interface circuit, which can include standalone components and integrated circuitry. In one example, user interface components or peripheral components, or both, couple to interface 514. Network interface 550 provides system 500 the ability to communicate with remote devices (e.g., servers or other computing devices) over one or more networks. Network interface 550 can include an Ethernet adapter, wireless interconnection components, cellular network interconnection components, USB, or other wired or wireless standards-based or proprietary interfaces. Network interface 550 can transmit data to a device that is in the same data center or rack or a remote device, which can include sending data stored in memory.

Some examples of network interface 550 are part of an infrastructure processing unit (IPU) or data processing unit (DPU), or used by an IPU or DPU. An xPU can refer at least to an IPU, DPU, GPU, GPGPU (general purpose computing on graphics processing units), or other processing units (e.g., accelerator devices). An IPU or DPU can include a network interface with one or more programmable pipelines or fixed function processors to perform offload of operations that can have been performed by a CPU. The IPU or DPU can include one or more memory devices.

In one example, system 500 includes one or more input/output (I/O) interface(s) 560. I/O interface 560 can include one or more interface components through which a user interacts with system 500 (e.g., audio, alphanumeric, tactile/touch, or other interfacing). Peripheral interface 570 can include additional types of hardware interfaces, such as, for example, interfaces to semiconductor fabrication equipment and/or electrostatic charge management devices.

In one example, system 500 includes storage subsystem 580. Storage subsystem 580 includes storage device(s) 584, which can be or include any conventional medium for storing data in a nonvolatile manner, such as one or more magnetic, solid state, and/or optical based disks. Storage 584 can be generically considered to be a "memory," although memory 530 is typically the executing or operating memory to provide instructions to processor 510. Whereas storage 584 is nonvolatile, memory 530 can include volatile memory (e.g., the value or state of the data is indeterminate if power is interrupted to system 500). In one example, storage subsystem 580 includes controller 582 to interface with storage 584. In one example controller 582 is a physical part of interface 512 or processor 510 or can include circuits or logic in both processor 510 and interface 514.

A power source (not depicted) provides power to the components of system 500. More specifically, power source typically interfaces to one or multiple power supplies in system 500 to provide power to the components of system 500.

Examples of systems may be implemented in various types of computing, smart phones, tablets, personal computers, and networking equipment, such as switches, routers, racks, and blade servers such as those employed in a data center and/or server farm environment.

### EXAMPLES

A system can comprise: a heater, a heat transfer coupler comprising a first face and a second face, wherein the first face is opposite the second face, wherein the heat transfer coupler comprises a cavity in the first face, and wherein the heat transfer coupler comprises first channels in the second face; and a pedestal wherein the pedestal is capable of reversibly attaching a substrate to which a semiconductor chip is to be bonded and wherein the heater is capable of supplying heat to the first face of the heat transfer coupler to cause conducting interconnections to be formed between the semiconductor chip attached to the second face and the substrate attached to the pedestal. The heat transfer coupler can comprise second channels wherein the second channels comprise a first end and a second end, and wherein the first end is coupled to the first channels and the second end is open to a face of the heat transfer coupler. The heat transfer coupler can comprise second channels wherein the second channels comprise a first end and a second end, and wherein the first end is coupled to the first channels and the second end is coupled to a third channel in the heater. The pedestal can be a vacuum pedestal and the pedestal can be capable of reversibly attaching a substrate through application of a vacuum to a surface of the substrate. The first channels in the second face can be capable of reversibly attaching a semiconductor chip when a vacuum is applied through the first channels. The cavity can be centered in the first face. The cavity can have an opening on a surface of the first face and the opening has a first area, wherein the semiconductor chip has a third face that has a second area, wherein the third face of the semiconductor chip meets the second face of the heat transfer coupler, and wherein the first area is between 5 % and 50 % of the second area. The cavity can have an opening on a surface of the first face and the opening can have a first area, wherein the semiconductor chip has a third face that has a second area, wherein the third face of the semiconductor chip meets the second face of the heat transfer coupler, and wherein the first area is between 10 % and 45 % of the second area.

A device can comprise: a body comprising a solid material; a cavity on a first side of the body; one or more first channels on a second side of the body, wherein the first side of the body is opposite the second side of the body, wherein the one or more first channels allow a semiconductor chip to be reversibly attached to the second side of the body through application of a vacuum to the one or more first channels; and one or more second channels wherein the one or more second channels are operably coupled to the one or more first channels and are capable of supplying a vacuum to the one or more second channels, wherein the one or more second channels are in the body, and wherein the one or more second channels are open to a surface of the body. The cavity can be centered in the first side of the body. The one or more first channels can be perpendicular to the one or more second channels. The at least one of the one or more second channels can have an end that is in the cavity. The body can be comprised of a ceramic material. The cavity can have an opening on a surface of the first side wherein the opening has a first area, wherein the semiconductor chip has a third face that has a second area, wherein the third face of the semiconductor chip meets the second face of the body, and wherein the first area is between 5 % and 50 % of the second area. The cavity can have an opening on a surface of the first side wherein the opening has a first area, wherein the semiconductor chip has a third face that has a second area, wherein the third face of the semiconductor chip meets the second face of the body, and wherein the first area is between 10 % and 45 % of the second area.

A method can comprise: placing a substrate and a semiconductor chip that are to be electrically coupled in a manufacturing tool wherein the manufacturing tool can comprise: a heater, and a heat transfer coupler comprising a first face and a second face, wherein the first face is opposite the second face, wherein the heat transfer coupler comprises a cavity in the first face, wherein the heat transfer coupler comprises first channels in the second face, wherein the heater is capable of supplying heat to the first face of the heat transfer coupler, and wherein a semiconductor chip is attached to the second face through a vacuum applied through the first channels; applying heat to the first face of the heat transfer coupler, to cause electrical connections to be formed between the semiconductor chip and the substrate; and removing the semiconductor chip and substrate from the manufacturing tool. The manufacturing tool can also be capable of applying mechanical pressure and wherein the electrical connections are also formed through application of mechanical pressure. The manufacturing tool can also comprise a pedestal and the substrate is placed on the pedestal and held in place by application of a vacuum. The cavity can also have an opening in the first face wherein the opening has a first area, wherein the semiconductor chip has a side that has a second area, wherein the side of the semiconductor chip meets the second face of the heat transfer coupler, and wherein the first area is between 10 % and 50 % of the second area. The cavity can also have an opening in the first face wherein the opening has a first area, wherein the semiconductor chip has a side that has a second area, wherein the side of the semiconductor chip meets the second face of the heat transfer coupler, and wherein the first area is between 20 % and 40 % of the second area.

Besides what is described herein, various modifications can be made to what is disclosed and implementations without departing from their scope. Therefore, the illustrations and examples herein should be construed in an illustrative, and not a restrictive sense.

The following section of the description relates to further examples. The numbered paragraphs in this section are not claims. The claims are set forth below in the later section headed "claims".
1. A system comprising: a heater, a heat transfer coupler comprising a first face and a second face, wherein the first face is opposite the second face, wherein the heat transfer coupler comprises a cavity in the first face, and wherein the heat transfer coupler comprises first channels in the second face; and a pedestal wherein the pedestal is capable of reversibly attaching a substrate to which a semiconductor chip is to be bonded and wherein the heater is capable of supplying heat to the first face of the heat transfer coupler to cause conducting interconnections to be formed between the semiconductor chip attached to the second face and the substrate attached to the pedestal.
2. The system of clause 1 wherein the heat transfer coupler comprises second channels wherein the second channels comprise a first end and a second end, and wherein the first end is coupled to the first channels and the second end is open to a face of the heat transfer coupler.
3. The system of clause 1 wherein the heat transfer coupler comprises second channels wherein the second channels comprise a first end and a second end, and wherein the first end is coupled to the first channels and the second end is coupled to a third channel in the heater.
4. The system of clause 1 wherein the pedestal is a vacuum pedestal and the pedestal is capable of reversibly attaching a substrate through application of a vacuum to a surface of the substrate.
5. The system of clause 1 wherein the first channels in the second face are capable of reversibly attaching a semiconductor chip when a vacuum is applied through the first channels.
6. The system of clause 1 wherein the cavity is centered in the first face.
7. The system of clause 1 wherein the cavity has an opening on a surface of the first face and the opening has a first area, wherein the semiconductor chip has a third face that has a second area, wherein the third face of the semiconductor chip meets the second face of the heat transfer coupler, and wherein the first area is between 5 % and 50 % of the second area.
8. The system of clause 1 wherein the cavity has an opening on a surface of the first face and the opening has a first area, wherein the semiconductor chip has a third face that has a second area, wherein the third face of the semiconductor chip meets the second face of the heat transfer coupler, and wherein the first area is between 10 % and 45 % of the second area.
9. A device comprising: a body comprising a solid material; a cavity on a first side of the body; one or more first channels on a second side of the body, wherein the first side of the body is opposite the second side of the body, wherein the one or more first channels allow a semiconductor chip to be reversibly attached to the second side of the body through application of a vacuum to the one or more first channels; and one or more second channels wherein the one or more second channels are operably coupled to the one or more first channels and are capable of supplying a vacuum to the one or more second channels, wherein the one or more second channels are in the body, and wherein the one or more second channels are open to a surface of the body.
10. The device of clause 9 wherein the cavity is centered in the first side of the body.
11. The device of clause 9 wherein the one or more first channels are perpendicular to the one or more second channels.
12. The device of clause 9 wherein at least one of the one or more second channels has an end that is in the cavity.
13. The device of clause 9 wherein the body is comprised of a ceramic material.
14. The device of clause 9 wherein the cavity has an opening on a surface of the first side and the opening has a first area, wherein the semiconductor chip has a third face that has a second area, wherein the third face of the semiconductor chip meets the second face of the body, and wherein the first area is between 5 % and 50 % of the second area.
15. The device of clause 9 wherein the cavity has an opening on a surface of the first side and the opening has a first area, wherein the semiconductor chip has a third face that has a second area, wherein the third face of the semiconductor chip meets the second face of the body, and wherein the first area is between 10 % and 45 % of the second area.
16. A method comprising: placing a substrate and a semiconductor chip that are to be electrically coupled in a manufacturing tool wherein the manufacturing tool comprises: a heater, and a heat transfer coupler comprising a first face and a second face, wherein the first face is opposite the second face, wherein the heat transfer coupler comprises a cavity in the first face, wherein the heat transfer coupler comprises first channels in the second face, wherein the heater is capable of supplying heat to the first face of the heat transfer coupler, and wherein a semiconductor chip is attached to the second face through a vacuum applied through the first channels; applying heat to the first face of the heat transfer coupler, to cause electrical connections to be formed between the semiconductor chip and the substrate; and removing the semiconductor chip and substrate from the manufacturing tool.
17. The method of clause 16 wherein the manufacturing tool is also capable of applying mechanical pressure and wherein the electrical connections are also formed through application of mechanical pressure.
18. The method of clause 16 wherein the manufacturing tool also comprises a pedestal and the substrate is placed on the pedestal and held in place by application of a vacuum.
19. The method of clause 16 wherein the cavity has an opening in the first face and the opening has a first area, wherein the semiconductor chip has a side that has a second area, wherein the side of the semiconductor chip meets the second face of the heat transfer coupler, and wherein the first area is between 10 % and 50 % of the second area.
20. The method of clause 16 wherein the cavity has an opening in the first face and the opening has a first area, wherein the semiconductor chip has a side that has a second area, wherein the side of the semiconductor chip meets the second face of the heat transfer coupler, and wherein the first area is between 20 % and 40 % of the second area.

## Claims

1. A system comprising:
a heater,
a heat transfer coupler comprising a first face and a second face, wherein the first face is opposite the second face, wherein the heat transfer coupler comprises a cavity in the first face, and wherein the heat transfer coupler comprises first channels in the second face; and
a pedestal wherein the pedestal is capable of reversibly attaching a substrate to which a semiconductor chip is to be bonded and wherein the heater is capable of supplying heat to the first face of the heat transfer coupler to cause conducting interconnections to be formed between the semiconductor chip attached to the second face and the substrate attached to the pedestal.

2. The system of claim 1 wherein the heat transfer coupler comprises second channels wherein the second channels comprise a first end and a second end, and wherein the first end is coupled to the first channels and the second end is open to a face of the heat transfer coupler.

3. The system of claim 1 wherein the heat transfer coupler comprises second channels wherein the second channels comprise a first end and a second end, and wherein the first end is coupled to the first channels and the second end is coupled to a third channel in the heater.

4. The system of claim 1 wherein the cavity is centered in the first face.

5. The system of any of claims 1-4 wherein the cavity has an opening on a surface of the first face and the opening has a first area, wherein the semiconductor chip has a third face that has a second area, wherein the third face of the semiconductor chip meets the second face of the heat transfer coupler, and wherein the first area is between 5 % and 50 % of the second area.

6. The system of any of claims 1-4 wherein the cavity has an opening on a surface of the first face and the opening has a first area, wherein the semiconductor chip has a third face that has a second area, wherein the third face of the semiconductor chip meets the second face of the heat transfer coupler, and wherein the first area is between 10 % and 45 % of the second area.

7. A device comprising:
a body comprising a solid material;
a cavity on a first side of the body;
one or more first channels on a second side of the body, wherein the first side of the body is opposite the second side of the body, wherein the one or more first channels allow a semiconductor chip to be reversibly attached to the second side of the body through application of a vacuum to the one or more first channels; and
one or more second channels wherein the one or more second channels are operably coupled to the one or more first channels and are capable of supplying a vacuum to the one or more second channels, wherein the one or more second channels are in the body, and wherein the one or more second channels are open to a surface of the body.

8. The device of claim 7 wherein the one or more first channels are perpendicular to the one or more second channels.

9. The device of claim 7 wherein at least one of the one or more second channels has an end that is in the cavity.

10. The device of any of claims 7-9 wherein the cavity has an opening on a surface of the first side and the opening has a first area, wherein the semiconductor chip has a third face that has a second area, wherein the third face of the semiconductor chip meets the second face of the body, and wherein the first area is between 5 % and 50 % of the second area.

11. The device of any of claims 7-9 wherein the cavity has an opening on a surface of the first side and the opening has a first area, wherein the semiconductor chip has a third face that has a second area, wherein the third face of the semiconductor chip meets the second face of the body, and wherein the first area is between 10 % and 45 % of the second area.

12. A method comprising:
placing a substrate and a semiconductor chip that are to be electrically coupled in a manufacturing tool wherein the manufacturing tool comprises:
a heater, and
a heat transfer coupler comprising a first face and a second face, wherein the first face is opposite the second face, wherein the heat transfer coupler comprises a cavity in the first face, wherein the heat transfer coupler comprises first channels in the second face, wherein the heater is capable of supplying heat to the first face of the heat transfer coupler, and wherein a semiconductor chip is attached to the second face through a vacuum applied through the first channels;
applying heat to the first face of the heat transfer coupler, to cause electrical connections to be formed between the semiconductor chip and the substrate; and
removing the semiconductor chip and substrate from the manufacturing tool.

13. The method of claim 12 wherein the manufacturing tool is also capable of applying mechanical pressure and wherein the electrical connections are also formed through application of mechanical pressure.

14. The method of any of claims 12-13 wherein the cavity has an opening in the first face and the opening has a first area, wherein the semiconductor chip has a side that has a second area, wherein the side of the semiconductor chip meets the second face of the heat transfer coupler, and wherein the first area is between 10 % and 50 % of the second area.

15. The method of any of claims 12-13 wherein the cavity has an opening in the first face and the opening has a first area, wherein the semiconductor chip has a side that has a second area, wherein the side of the semiconductor chip meets the second face of the heat transfer coupler, and wherein the first area is between 20 % and 40 % of the second area.
